(19) Europäisches Patentamt
European Patent Office
Office européen des brevets

(11) EP 4 269 094 B1

(12) EUROPEAN PATENT SPECIFICATION

(45) Date of publication and mention of the grant of the patent:
**03.12.2025 Bulletin 2025/49**

(21) Application number: **21910853.7**

(22) Date of filing: **22.12.2021**

(51) International Patent Classification (IPC):
***B32B 27/00*** (2006.01) ***B32B 27/18*** (2006.01)
***B41C 1/00*** (2006.01) ***B41N 1/12*** (2006.01)
***G03F 1/00*** (2012.01) ***G03F 7/00*** (2006.01)
***G03F 7/20*** (2006.01) ***G03F 7/32*** (2006.01)

(52) Cooperative Patent Classification (CPC):
**G03F 7/322; G03F 7/202; G03F 7/343**

(86) International application number:
**PCT/JP2021/047545**

(87) International publication number:
**WO 2022/138713 (30.06.2022 Gazette 2022/26)**

# (54) IMAGE FORMATION LAMINATE AND METHOD FOR MANUFACTURING FLEXOGRAPHIC PRINTING PLATE

BILDERZEUGUNGSLAMINAT UND VERFAHREN ZUR HERSTELLUNG EINER FLEXODRUCKPLATTE

STRATIFIÉ DE FORMATION D’IMAGE ET PROCÉDÉ DE FABRICATION D’UNE PLAQUE D’IMPRESSION FLEXOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.12.2020 JP 2020212516**

(43) Date of publication of application:
**01.11.2023 Bulletin 2023/44**

(73) Proprietor: **FUJIFILM Corporation**
**Tokyo 106-8620 (JP)**

(72) Inventor: **WATANABE Kazuki**
**Haibara-gun, Shizuoka 421-0396 (JP)**

(74) Representative: **HGF**
**HGF Limited**
**4th Floor, 1 City Square**
**Leeds LS1 2AL (GB)**

(56) References cited:
**WO-A1-2007/028294**
**WO-A1-2019/160702**
**WO-A1-2020/158778**
**CN-A- 102 591 137**
**JP-A- 2001 324 815**
**JP-A- 2008 299 213**
**JP-A- 2009 020 449**
**JP-A- 2016 524 718**
**US-A1- 2004 137 367**
**US-A1- 2010 167 209**
**US-A1- 2019 258 154**

- **ANONYMOUS: "Epolight (TM) 1117 Near Infrared Dye; Rev. 04/13", EPOLIN INC. TECHNICAL DATA SHEET, pages 1 - 1, XP009537824, Retrieved from the Internet <URL:https://www.epolin.com/epolight/epolight1117/>**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 269 094 B1

## Description

### BACKGROUND OF THE INVENTION

1. Field of the Invention

The present invention relates to a laminate for forming an image and a manufacturing method of a flexographic printing plate using the same.

2. Description of the Related Art

A precursor of a flexographic printing plate generally includes a photosensitive resin layer formed of a photosensitive resin composition on a support formed of a polyester film or the like. The flexographic printing plate is formed by exposing a surface of the photosensitive resin layer of the precursor to a predetermined image and then removing a resin in a portion not exposed.

In a so-called analog-type flexographic printing plate precursor, a negative film (mask) on which the predetermined image is already formed is placed on the photosensitive resin layer, and the predetermined image is exposed on the surface of the photosensitive resin layer through this negative film.

As a laminate for forming an image which forms such a negative film (mask), for example, JP2016-524718A discloses a material for forming an image, which includes, in the following order, a carrier sheet, a barrier layer containing a first infrared absorbing compound, and a heat-sensitive image forming layer containing a second infrared absorbing compound and a second ultraviolet absorbing compound, in which an IR absorbing dye is used as the first infrared absorbing compound and the second infrared absorbing compound (for example, see [Claim 1], [0154], [0167], [0169], and the like).

US2019/258154A1 is a further document that illustrates relevant concepts known in the field.

### SUMMARY OF THE INVENTION

As a result of studying the material for forming an image disclosed in JP2016-524718A, the present inventors have found that there is room for improvement in sensitivity of the drawing formed on the heat-sensitive image forming layer (infrared ablation layer).

Therefore, from the viewpoint of improving the sensitivity of the heat-sensitive image forming layer, the present inventors have found that, in a case where an absorption wavelength of the infrared absorbing dye is changed to a longer wavelength side than 830 nm (for example, 900 to 1200 nm) so that a long wavelength exposure light source (for example, a fiber laser of 1070 nm, and the like) can be applied, the material for forming an image has no manufacturing suitability.

Therefore, an object of the present invention is to provide a laminate for forming an image with high sensitivity of the heat-sensitive image forming layer and excellent manufacturing suitability, and a manufacturing method of a flexographic printing plate using the same.

As a result of intensive studies to achieve the above-described object, the present inventors have found that, in a case where an infrared absorbing dye contained in a barrier layer and a heat-sensitive image forming layer is a compound having an absorption at a wavelength of 1070 nm and having a mass absorption coefficient at the wavelength of 1070 nm of 50 L/(g·cm) or more, and the barrier layer and the heat-sensitive image forming layer further contain an infrared absorbing dye having an absorption at a wavelength of 830 nm, the sensitivity of the heat-sensitive image forming layer is increased and the manufacturing suitability of the laminate for forming an image is improved, and have completed the present invention.

That is, the present inventors have found that the above-described object can be achieved by adopting the configurations which have been defined in the claims.

According to the present invention, it is possible to provide a laminate for forming an image with high sensitivity of the heat-sensitive image forming layer and excellent manufacturing suitability, and a manufacturing method of a flexographic printing plate using the same.

### BRIEF DESCRIPTION OF THE DRAWINGS

Fig. 1 is a schematic cross-sectional view showing an example of a laminate for forming an image according to the embodiment of the present invention.

## DESCRIPTION OF THE PREFERRED EMBODIMENTS

Hereinafter, the present invention will be described in detail.

The description of configuration requirements described below may be made on the basis of representative embodiments of the present invention, but it should not be construed that the present invention is limited to those embodiments. The scope of the invention is defined by the claims, only.

In the specification of the present application, the numerical range expressed by using "to" means a range including the numerical values before and after "to" as the lower limit value and the upper limit value.

In addition, in this specification, for each component, one kind of substance corresponding to each component may be used alone, or two or more kinds thereof may be used in combination. Here, in a case where two or more kinds of substances are used in combination for each component, the content of the component indicates the total content of the substances used in combination, unless otherwise specified.

[Laminate for forming image]

The laminate for forming an image according to the embodiment of the present invention is a laminate for forming an image, which is for forming a mask used for manufacturing a flexographic printing plate and includes, in the following order, a carrier sheet, a barrier layer, and a heat-sensitive image forming layer.

In addition, the above-described barrier layer contains a first infrared absorbing dye.

In addition, the above-described heat-sensitive image forming layer contains an ultraviolet absorber and a second infrared absorbing dye.

In addition, both of the first infrared absorbing dye and the second infrared absorbing dye are a compound having an absorption at a wavelength of 1070 nm and having a mass absorption coefficient at the wavelength of 1070 nm of 50 L/(g·cm) or more.

In addition, both of the above-described barrier layer and the above-described heat-sensitive image forming layer contain a third infrared absorbing dye having an absorption at a wavelength of 830 nm.

Fig. 1 is a schematic cross-sectional view showing an example of the laminate for forming an image according to the embodiment of the present invention.

A laminate 10 for forming an image shown in Fig. 1 includes a carrier sheet 6, a barrier layer 3, and a heat-sensitive image forming layer 4 in this order.

In addition, as shown in Fig. 1, the laminate for forming an image according to the embodiment of the present invention may include an overcoat layer 5.

As described above, in the present invention, since the infrared absorbing dye (respectively the first infrared absorbing dye and the second infrared absorbing dye) contained in the barrier layer and the heat-sensitive image forming layer is a compound having an absorption at a wavelength of 1070 nm and having a mass absorption coefficient at the wavelength of 1070 nm of 50 L/(g·cm) or more, and the barrier layer and the heat-sensitive image forming layer further contain an infrared absorbing dye (third infrared absorbing dye) having an absorption at a wavelength of 830 nm, the sensitivity of the heat-sensitive image forming layer is increased and the manufacturing suitability of the laminate for forming an image is improved.

Although the details thereof are not clear, the present inventors have presumed as follows.

First, it is considered that the reason why the sensitivity of the heat-sensitive image forming layer is increased is that the absorption wavelengths of the first infrared absorbing dye and the second infrared absorbing dye are 1070 nm, so that it is easy to apply a fiber laser.

On the other hand, it is considered that the manufacturing suitability is caused by high crystallinity of the first infrared absorbing dye and the second infrared absorbing dye.

Therefore, in the present invention, by using the third infrared absorbing dye having an absorption at a wavelength of 830 nm in combination with the first infrared absorbing dye or the second infrared absorbing dye, it is considered that the manufacturing suitability is improved because crystallization of the first infrared absorbing dye and the second infrared absorbing dye can be suppressed.

Hereinafter, the infrared absorbing dye will be described in detail, and then each layer configuration of the laminate for forming an image according to the embodiment of the present invention will be described in detail.

[First infrared absorbing dye and second infrared absorbing dye]

Both of the first infrared absorbing dye contained in the barrier layer and the second infrared absorbing dye contained in the heat-sensitive image forming layer are a compound (hereinafter, also abbreviated as "specific dye") having an absorption at a wavelength of 1070 nm and having a mass absorption coefficient at the wavelength of 1070 nm of 50 L/(g·cm) or more.

In addition, the above-described specific dye has a mass absorption coefficient of more preferably 50 to 200 L/(g·cm) and still more preferably 50 to 100 L/(g·cm).

Here, the mass absorption coefficient refers to a value calculated by the following method.

First, 10 mg of the infrared absorbing dye to be measured is diluted with 1 L of methyl ethyl ketone to obtain a measurement solution.

Next, an absorption spectrum of the obtained measurement liquid is measured for an infrared absorption range (200 nm to 3300 nm). As a measuring device, UH4150 manufactured by Hitachi High-Tech Science Corporation is used.

Next, the mass absorption coefficient at the wavelength of 1070 nm is obtained from the obtained absorption spectrum (unit: L/g·cm). Specifically, a transmittance T (%) at a cell length L (cm) in a solution having a designated concentration C (g/L) is measured, and a mass absorption coefficient k is calculated from the following expression.

$$\text{Mass absorption coefficient } k = A/CL \text{ (unit L/(g·cm))}$$

$$\text{Absorbance } A = -\log_{10}(T)$$

In the present invention, from the reason that the sensitivity of the heat-sensitive image forming layer is further increased, it is preferable that the above-described specific dye as the first infrared absorbing dye and the second infrared absorbing dye is a compound represented by Formula (1).

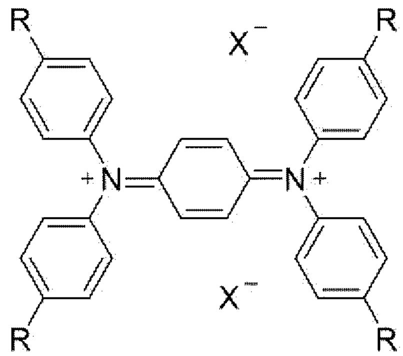

(1)

In Formula (1), R represents a monovalent organic group, in which a plurality of R's may be the same or different from each other.

In addition, in Formula (1), $X^-$ represents a monovalent anion, in which a plurality of $X^-$'s may be the same or different from each other.

Examples of the monovalent organic group represented by R in Formula (1) include an alkyl group, a cycloalkyl group, an aryl group, an aralkyl group, an alkenyl group, and $-NR^{11}R^{12}$ ($R^{11}$ and $R^{12}$ each independently represent a hydrogen atom or a hydrocarbon group), and these groups may further have a substituent.

Examples of the alkyl group include a linear or branched alkyl group having 1 to 18 carbon atoms, and specific examples thereof include a methyl group, an ethyl group, a propyl group, a butyl group, a pentyl group, a tert-pentyl group, and an n-hexyl group.

Examples of the cycloalkyl group include a monocyclic or polycyclic cycloalkyl group having 3 to 20 carbon atoms, and specific examples thereof include a cyclopentyl group, a cyclopentylmethyl group, a cyclopentylethyl group, a cyclohexyl group, a cyclohexylmethyl group, and a cyclohexylethyl group.

Examples of the aryl group include an aryl group having 6 to 14 carbon atoms, and specific examples thereof include a phenyl group, a methylphenyl group, a tolyl group, a xylyl group, a naphthyl group, an anthryl group, a phenanthryl group, and a pyrenyl group.

Examples of the aralkyl group include an aralkyl group having 7 to 20 carbon atoms, and specific examples thereof include a benzyl group, a phenethyl group, a 2-phenylethan-2-yl group, and a naphthylmethyl group.

Examples of the alkenyl group include an alkenyl group having 3 to 20 carbon atoms, and specific examples thereof include a vinyl group and an allyl group.

Examples of the hydrocarbon group represented as one aspect of $R^{11}$ and $R^{12}$ include the above-described alkyl group and the above-described aryl group.

Examples of the monovalent anion represented by $X^-$ in Formula (1) include $ClO_4^-$, $PF_6^-$, $BF_4^-$, and a bis(trifluoromethanesulfonyl)imide anion represented by the following formula.

In addition, as the monovalent anion of $X^-$, anions described in paragraphs [0016] to [0023] of JP2011-38007A can also be used.

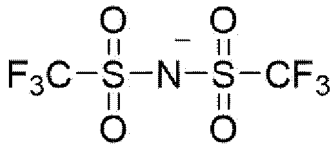

[Third infrared absorbing dye]

In the present invention, as described above, both of the barrier layer and the heat-sensitive image forming layer further contain a third infrared absorbing dye having an absorption at a wavelength of 830 nm.

Here, as the third infrared absorbing dye, a dye having an absorption at a wavelength of 830 nm can be appropriately selected and used from known infrared absorbing dyes, and examples thereof include an azo dye, a squarylium dyes, a croconate dye, a triarylamine dye, a thiazolium dyes, an indolium dyes, an oxonol dye, an oxazolium dye, a cyanine dye, a merocyanine dye, a phthalocyanine dye, an indocyanine dye, an indotricarbocyanine dye, an oxatricarbocyanine dyes, a thiocyanine dye, a thiatricarbocyanine dye, a merocyanine dye, a cryptocyanine dye, a naphthalocyanine dye, a polyaniline dye, a polypyrrole dye, a polythiophene dye, a chalcogenopyryloarylidene and bi(chalcogenopyryllo)polymethine dye, an oxindolizine dye, a pyrylium dye, a pyrazoline azo dye, an oxazine dye, a naphthoquinone dye, an anthraquinone dye, a quinoneimine dye, a methine dye, an arylmethine dye, a squaraine dye, an oxazole dye, a croconine dye, a porphyrin dye, and substituted or ionic forms of any of these dyes.

From the reason that the effects of the present invention are more excellent, the third infrared absorbing dye is preferably a cyanine dye, and more preferably a closed-type cyanine dye. Examples of such a dye include IR-813 (p-toluenesulfonate) (manufactured by Tokyo Chemical Industry Co., Ltd.).

[Carrier sheet]

The carrier sheet included in the laminate for forming an image according to the embodiment of the present invention is not particularly limited, but is preferably a transparent polymer film and may be one layer alone or two or more layers laminated.

Here, the "transparent" in the present invention means that a transmittance of visible light is 60% or more, preferably 80% or more and particularly preferably 90% or more.

Examples of a material of the polymer film include cellulose-based polymers; acrylic polymers having an acrylic acid ester polymer such as polymethyl methacrylate and a lactone ring-containing polymer; thermoplastic norbornene-based polymers; polycarbonate-based polymers; polyester-based polymers such as polyethylene terephthalate, polyethylene naphthalate, and a fluoropolyester polymer; styrene-based polymers such as polystyrene and an acrylonitrile-styrene copolymer (AS resin); polyolefin-based polymers such as polyethylene, polypropylene, an ethylene-propylene copolymer, and polybutadiene; vinyl chloride-based polymers; amide-based polymers such as nylon and aromatic polyamide; imide-based polymers; sulfone-based polymers; polyether sulfone-based polymers; polyether ether ketone-based polymers; polyphenylene sulfide-based polymers; vinylidene chloride-based polymers; vinyl alcohol-based polymers; vinyl butyral-based polymers; arylate-based polymers; polyoxymethylene-based polymers; epoxy-based polymers; and polymers obtained by mixing these polymers.

In addition, a surface (surface on which the barrier layer is formed) of the carrier sheet may be subjected to peeling treatment for suppressing adhesion of the barrier layer and enhancing peelability of the carrier sheet. Examples of such a peeling treatment include a method of applying a peeling agent to the surface of the carrier sheet to form a peeling layer. Examples of the peeling agent include a silicone-based peeling agent and an alkyl-based peeling agent.

A film thickness of the carrier sheet is preferably 25 to 250 μm.

[Barrier layer]

The barrier layer included in the laminate for forming an image according to the embodiment of the present invention is a layer containing the above-described first infrared absorbing dye, and is a layer which functions as an infrared ablation layer together with the heat-sensitive image forming layer described later.

<Content of first infrared absorbing dye>

A content of the above-described first infrared absorbing dye contained in the barrier layer is preferably 2% to

75% by mass and more preferably 5% to 70% by mass with respect to the mass of the barrier layer, that is, the total mass of solid contents of a composition used for formation.

<Content of third infrared absorbing dye>

From the reason that the effects of the present invention are more excellent, a content of the above-described third infrared absorbing dye contained in the barrier layer is preferably 2% to 75% by mass and more preferably 5% to 70% by mass with respect to the mass of the barrier layer, that is, the total mass of solid contents of a composition used for formation.

<Proportion of content of third infrared absorbing dye to content of first infrared absorbing dye>

From the reason that the effects of the present invention are more excellent, a proportion (mass ratio) of the content of the above-described third infrared absorbing dye contained in the barrier layer to the content of the above-described first infrared absorbing dye contained in the barrier layer is preferably 0.5 to 2 and more preferably 0.8 to 1.2.

In the present invention, from the reason that it is possible to suppress the occurrence of white spots in the line drawing in a case of being used for a flexographic printing plate, in the above-described barrier layer, it is preferable that a content of a compound having substantially no absorption in a wavelength range of 900 to 1200 nm and having an absorption in a wavelength range of 300 to 400 nm (hereinafter, also abbreviated as "UV absorbing impurity") is 0% by mass or more and less than 0.1% by mass with respect to a mass of the above-described barrier layer.

Here, the "substantially having no absorption" refers to that an absorbance of the UV absorbing impurity in a 1.0 g/liter dichloromethane solution at a cell length of 1 cm is 5.0 or less, preferably 2.0 or less and more preferably 0 to 1.0.

In addition, the content of the UV absorbing impurity is preferably 0% by mass, that is, it is preferable that the UV absorbing impurity is not contained.

<Thermally decomposable compound>

The barrier layer preferably contains a thermally decomposable compound as a binder.

Examples of the thermally decomposable compound include ammonium nitrate, potassium nitrate, sodium nitrate, nitrocellulose, polyvinylpyrrolidone, an azo compound, a diazo compound, a hydrazine derivative, an acrylic resin, a metal, and a metal oxide.

Among these, from the viewpoint of solution coatability, a polymer compound is preferable, and polyvinylpyrrolidone, nitrocellulose, or an acrylic resin is more preferable.

A content of the thermally decomposable compound is preferably 80% by mass or less and more preferably 15% to 60% by mass with respect to the mass of the barrier layer, that is, the total mass of solid contents of a composition used for formation.

A film thickness of the barrier layer is preferably 0.1 to 6 μm and more preferably 0.2 to 3 μm.

[Heat-sensitive image forming layer]

The heat-sensitive image forming layer included in the laminate for forming an image according to the embodiment of the present invention is a layer containing an ultraviolet absorber and the above-described second infrared absorbing dye, and is a layer which functions as the infrared ablation layer.

<Content of second infrared absorbing dye>

A content of the above-described second infrared absorbing dye contained in the heat-sensitive image forming layer is preferably 2% to 75% by mass and more preferably 5% to 70% by mass with respect to the mass of the heat-sensitive image forming layer, that is, the total mass of solid contents of a composition used for formation.

<Content of third infrared absorbing dye>

From the reason that the effects of the present invention are more excellent, a content of the above-described third infrared absorbing dye contained in the heat-sensitive image forming layer is preferably 2% to 75% by mass and more preferably 5% to 70% by mass with respect to the mass of the heat-sensitive image forming layer, that is, the total mass of solid contents of a composition used for formation.

<Proportion of content of third infrared absorbing dye to content of second infrared absorbing dye>

From the reason that the effects of the present invention are more excellent, a proportion (mass ratio) of the content of the above-described third infrared absorbing dye contained in the heat-sensitive image forming layer to the content of the above-described second infrared absorbing dye contained in the heat-sensitive image forming layer is preferably 0.5 to 2 and more preferably 0.8 to 1.2.

<Ultraviolet absorber>

Suitable examples of the ultraviolet absorber contained in the heat-sensitive image forming layer include a compound having an absorption in a range of 300 nm to 400 nm.
Specific examples of the above-described compound include a benzotriazole-based compound, a triazine-based compound, a benzophenone-based compound, and carbon black.
In addition, specific examples of the above-described compound also include metal compounds such as iron powder, a diamine-based metal complex, a dithiol-based metal complex, a phenolthiol-based metal complex, a mercaptophenol-based metal complex, an aryl aluminum metal salt, a crystal water-containing inorganic compound, copper sulfate, chromium sulfide, and a silicate compound; and metal oxides such as titanium oxide, vanadium oxide, manganese oxide, iron oxide, cobalt oxide, and tungsten oxide.
Among these, it is preferable to use a benzophenone-based compound or carbon black.
A content of the ultraviolet absorber is preferably 0.1% to 75% by mass and more preferably 1% to 50% by mass with respect to the mass of the heat-sensitive image forming layer, that is, the total mass of solid contents of a composition used for formation.

<Thermally decomposable compound>

The heat-sensitive image forming layer preferably contains a thermally decomposable compound as a binder.
The thermally decomposable compound is the same as that described in the barrier layer, and the suitable examples thereof and the content thereof are also the same.
A film thickness of the heat-sensitive image forming layer is preferably 0.1 to 6 μm and more preferably 0.5 to 3 μm.

[Overcoat layer]

As shown in Fig. 1, the laminate for forming an image according to the embodiment of the present invention may include an overcoat layer (hereinafter, also referred to as "protective layer").
Examples of the overcoat layer include a layer having characteristics such as prevention of scratches in the heat-sensitive image forming layer, resistance to infrared ablation, and suppression of mass transfer between the mask and the photosensitive resin layer.
Examples of the overcoat layer having such characteristics include layers containing a methacrylic acid copolymer (for example, a copolymer of ethyl methacrylate and methacrylic acid) and one or more fluoropolymer particles dispersed therein, as described in US6259465B (Tuttetal.), but the overcoat layer is not limited thereto.
In addition, the overcoat layer preferably contains a water-soluble polymer.
Here, the water-soluble polymer refers to a polymer which dissolves 1 g or more in 100 g of pure water at 70°C and does not precipitate even in a case where the solution of 1 g of the polymer dissolved in 100 g of pure water at 70°C is cooled to 25°C.
Examples of such a water-soluble polymer include polyvinyl alcohols, modified polyvinyl alcohols, polyvinylpyrrolidone, water-soluble cellulose derivatives, polyethylene glycol, and poly(meth)acrylonitriles.
A film thickness of the overcoat layer is preferably 0.01 to 1 μm and more preferably 0.05 to 0.5 μm.

[Manufacturing method of flexographic printing plate]

The manufacturing method of a flexographic printing plate according to the embodiment of the present invention is a manufacturing method of a flexographic printing plate having a non-image area and an image area, the manufacturing method including:

a mask forming step of forming an image on the heat-sensitive image forming layer included in the above-described laminate for forming an image according to the embodiment of the present invention to form a mask;
a lamination step of, after the above-described mask forming step, laminating the above-described mask on a

photosensitive resin layer of a flexographic printing plate precursor including a support and the photosensitive resin layer;
an exposure step of, after the above-described lamination step, imagewise exposing the above-described photosensitive resin layer through the above-described mask;
a peeling step of, after the above-described exposure step, peeling off the above-described mask from the above-described photosensitive resin layer; and
a development step of, after the above-described peeling step, performing development using a developer to form a non-image area and an image area.

[Mask forming step]

The above-described mask forming step is a step of forming an image on the heat-sensitive image forming layer to form a mask to be used in the exposure step described later. As described above, since the above-described barrier layer included in the laminate for forming an image according to the embodiment of the present invention is a layer which functions as an infrared ablation layer together with the heat-sensitive image forming layer, in a case where an image is formed on the heat-sensitive image forming layer, the image is simultaneously formed on the barrier layer.
Here, in the heat-sensitive image forming layer, in a case of being irradiated with an infrared laser, the action of the second infrared absorbing dye generates heat, which decomposes the thermally decomposable compound to remove, that is, to laser-ablate the heat-sensitive image forming layer.
Therefore, by selectively laser-ablating the heat-sensitive image forming layer based on the image data, it is possible to obtain an image mask capable of forming a latent image on the photosensitive resin layer.
For the infrared laser irradiation, an infrared laser having an oscillation wavelength in a range of 750 nm to 3000 nm is used.
Examples of such a laser include a solid-state laser such as a ruby laser, an Alexandrite laser, a perovskite laser, an Nd-YAG laser, and an emerald glass laser; a semiconductor laser such as InGaAsP, InGaAs, and GaAsAl; and a coloring agent laser such as a Rhodamine coloring agent.
In addition, a fiber laser which amplifies these light sources with a fiber can also be used.
Among these, from the viewpoint that the sensitivity of the heat-sensitive image forming layer is increased, it is preferable to use an exposure light source having an oscillation wavelength of 900 to 1200 nm, and it is more preferable to use a fiber laser.

[Lamination step]

The above-described lamination step is a step of, after the above-described mask forming step, laminating the above-described mask on a photosensitive resin layer of a flexographic printing plate precursor including a support and the photosensitive resin layer.

<Flexographic printing plate precursor>

The flexographic printing plate precursor used in the above-described lamination step is not particularly limited as long as it includes a support and a photosensitive resin layer, and a known flexographic printing plate precursor in the related art can be appropriately used.

(Support)

A material used for the support included in the flexographic printing plate precursor is not particularly limited, and a support with high dimensional stability is preferably used. Examples thereof include metals such as steel, stainless steel, and aluminum; polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; glass fiber reinforced plastic resin (such as epoxy resin and phenolic resin); and cloth and paper.
From the viewpoint of dimensional stability and availability, the support is preferably a polymer film or cloth, and more preferably a polymer film. The morphology of the support is determined by whether the polymer layer is sheet-like or sleeve-like.
As the cloth, plain or twill weave fabrics and various knitted fabrics of natural fibers such as cotton, linen, silk, and wool or synthetic fibers such as acetate, vinylon, vinylidene, polyvinyl chloride, acrylic, polypropylene, polyethylene, polyurethane, fluorine filament, polyclar, rayon, nylon, polyamide, and polyester, or nonwoven fabrics can be used.
Examples of the polymer film include a film formed of various polymers such as polyester (for example,

polyethylene terephthalate (PET), polybutylene terephthalate (PBT), polyethylene naphthalate (PEN), polyimide (PI), polyamide, liquid crystal polymer (LCP), and polyacrylonitrile (PAN)), plastic resins such as polyvinyl chloride, synthetic rubber such as styrene-butadiene rubber, and glass fiber reinforced plastic resin (such as epoxy resin and phenolic resin). Among these, from the viewpoint of dimensional stability and the like, a polyester film is preferable.

Examples of the above-described polyester film include a PET film, a PBT film, and a PEN film, and from the viewpoint of dimensional stability and the like, a polyethylene terephthalate (PET) film is preferable.

A film thickness of the support is not particularly limited, but from the viewpoint of dimensional stability and handleability, it is preferably 5 to 3000 μm, more preferably 50 to 2000 μm, and still more preferably 100 to 1000 μm.

(Photosensitive resin layer)

The photosensitive resin layer included in the flexographic printing plate precursor is not particularly limited, and the photosensitive resin layer can be formed of a known photosensitive resin composition in the related art. For example, the photosensitive resin layer can be formed of a resin composition containing a water-dispersible latex, rubber, a photopolymerizable monomer, a photopolymerization initiator, and a surfactant.

In the present invention, from the reason that it is possible to suppress the occurrence of white spots in the line drawing in a case of being used for a flexographic printing plate, it is preferable that the photosensitive resin layer contains a monomer, a polymerization initiator, a base polymer, and water-dispersible particles, in which the water-dispersible particles have a carbon-carbon double bond, and a carbon-carbon double bond amount on a surface of the water-dispersible particles is 21 or less. It is considered that this is because, in a case where the photosensitive resin layer is formed, fusion welding of the water-dispersible particles, which can occur during applying and drying, is suppressed, so that any unwanted image formation caused by the above-described weakly exposed portion can be removed by the development.

Such a photosensitive resin layer is described in paragraphs [0016] to [0044] of WO2020/158778A.

A film thickness of the photosensitive resin layer is preferably 0.2 to 6 mm.

<Laminating method>

The method of laminating the mask on the photosensitive resin layer of the flexographic printing plate precursor is not particularly limited, and examples thereof include a method of pressure-bonding using an adhesive and a method (thermal lamination) of bonding by passing through heating rolls with a hot-melt adhesive film sandwiched between them.

Examples of the above-described adhesive include a pressure sensitive adhesive, and specifically, suitable examples thereof include an acrylic pressure sensitive adhesive using an acrylic polymer as a base polymer.

[Exposure step]

The above-described exposure step is a step of imagewise exposing the photosensitive resin layer through the mask obtained in the above-described mask forming step, and by imagewise irradiating the photosensitive resin layer with ultraviolet rays, crosslinking and/or polymerization of regions irradiated with the ultraviolet rays can be induced to be cured.

[Peeling step]

The above-described peeling step is a step of, after the above-described exposure step, peeling off the above-described mask from the above-described photosensitive resin layer.

The method of peeling off the above-described mask from the above-described photosensitive resin layer is not particularly limited, and the mask can be peeled off by a method such as pulling.

[Development step]

The above-described development step is a step of performing development using a developer to form a non-image area and an image area.

The developer used in the above-described development step is not particularly limited, and known developer in the related art can be used. However, from the viewpoint of reducing the environmental load, it is preferable to use a developer containing 50% by mass or more of water (hereinafter, also abbreviated as "aqueous developer"). The developer may be an aqueous solution or a suspension (for example, an aqueous dispersion liquid).

In addition, a content of water contained in the aqueous developer is preferably 80% to 99.99% by mass and more preferably 90% to 99.9% by mass with respect to the total mass of the aqueous developer.

In the present invention, it is preferable that the aqueous developer contains a surfactant represented by Formula

(2).

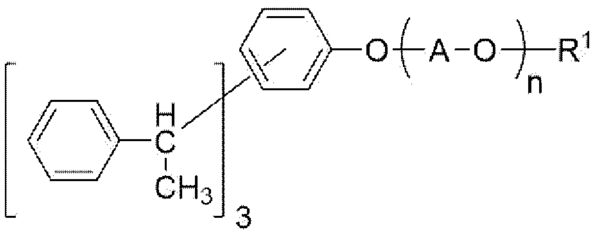

(2)

In Formula (2), A represents an alkylene group having 2 to 4 carbon atoms, $R^1$ represents a hydrogen atom or a substituent, and n represents an integer of 1 to 100. **In** a case where n is an integer of 2 to 100, a plurality of A's may be the same or different from each other.

A in Formula (2) represents an alkylene group having 2 to 4 carbon atoms, and is preferably an alkylene group having 2 or 3 carbon atoms and more preferably an ethylene group or an n-propylene group.

Examples of the substituent represented by one aspect of $R^1$ in Formula (2) include an alkyl group, an alkoxy group, an alkylcarbonyl group, an alkoxycarbonyl group, an alkylcarbonyloxy group, an alkylamino group, a dialkylamino group, an alkylamide group, an alkenyl group, an alkynyl group, a halogen atom, a cyano group, a nitro group, an alkylthiol group, and an N-alkyl carbamate group, and among these, an alkyl group is preferable.

As the alkyl group which is a suitable example of the substituent, for example, an alkyl group having 1 to 6 carbon atoms is preferable, and an alkyl group having 1 to 4 carbon atoms is more preferable. Specific examples thereof include a methyl group, an ethyl group, a propyl group, and an n-butyl group.

$R^1$ in Formula (2) represents a hydrogen atom or a substituent, and from the reason that the dispersibility of development scum is improved, $R^1$ is preferably a hydrogen atom.

n in Formula (2) represents an integer of 1 to 100, and from the reason that the dispersibility of development scum is improved, n is preferably an integer of 1 to 30, more preferably an integer of 5 to 20, and still more preferably an integer of 5 to 15.

[Rinse step]

It is preferable that the manufacturing method of a flexographic printing plate according to the embodiment of the present invention includes a rinse step of, after the above-described development step, rinsing surfaces of the non-image area and the image area formed in the above-described development step with water.

As a rinsing method in the rinse step, a method of washing with tap water, a method of spraying high pressure water, a method of rubbing the surfaces of the non-image area and the image area with a brush using a batch-type or transport-type brush type washing machine as a developing machine for flexographic printing plates mainly in the presence of water, and the like may be used.

Examples

Hereinafter, the present invention will be described in more detail with reference to examples. Materials, amounts used, ratios, treatment contents, treatment procedures, and the like shown in the following examples can be appropriately changed insofar as being represented by the scope of the invention which is defined by the claims, only.

[Example 1]

[Production of laminate for infrared ablation]

51.1 parts by mass of acetone and 41.8 parts by mass of cyclopentanone were added to 1.3 parts by mass of the third infrared absorbing dye (IR-813, p-toluenesulfonate, manufactured by Tokyo Chemical Industry Co., Ltd.), 1.3 parts by mass of the first infrared absorbing dye (CIR-RL, manufactured by Japan Carlit Co., Ltd.) and 4.5 parts by mass of the nitrocellulose (H1/8, manufactured by taihei chemicals limited), and the mixture was stirred until uniform to obtain a coating solution for a barrier layer.

Next, the coating solution for a barrier layer was applied onto one surface of a PET film having a thickness of 125 μm [carrier sheet] with a bar coater such that a thickness after drying was 0.4 μm, and then dried for 2 minutes in an oven set at 90°C to obtain a barrier layer.

90.5 parts by mass of methyl ethyl ketone was added to 1.2 parts by mass of the third infrared absorbing dye

(IR-813, p-toluenesulfonate, manufactured by Tokyo Chemical Industry Co., Ltd.), 1.2 parts by mass of the second infrared absorbing dye (CIR-RL, manufactured by Japan Carlit Co., Ltd.), 1.3 parts by mass of 2,2',4,4'-tetrahydroxybenzophenone (manufactured by FUJIFILM Wako Chemical Corporation), 1.4 parts by mass of curcumin (manufactured by FUJIFILM Wako Chemical Corporation), and 4.3 parts by mass of nitrocellulose (H1/8, manufactured by taihei chemicals limited), and the mixture was stirred until uniform to obtain a coating solution for a heat-sensitive image forming layer.

Next, the coating solution for a heat-sensitive image forming layer was applied onto an upper surface of the barrier layer with a bar coater such that a thickness after drying was 1.4 μm, and then dried for 2 minutes in an oven set at 90°C to obtain a heat-sensitive image forming layer.

57 parts by mass of a water-soluble binder (PVA-205, manufactured by KURARAY CO., LTD.), 13 parts by mass of polytetrafluoroethylene (PTFE) water-dispersible particles (Fluon AD915E, manufactured by Asahi Glass Co., Ltd.), 22 parts by mass of polyether-modified polydimethylsiloxane (Byk-333, manufactured by BYK Chemie), and 7.5 parts by mass of a surfactant (Surfynol FS-80, manufactured by Air Products and Chemicals, Inc.) were mixed with each other, and then the mixture was diluted with a mixed solution of water/ethanol = 4:1 so that the solid content was 0.3%, thereby obtaining a coating solution for a protective layer.

Next, the coating solution for a protective layer was applied onto an upper surface of the heat-sensitive image forming layer with a bar coater such that a thickness after drying was 0.1 μm, and then dried for 2 minutes in an oven set at 90°C to obtain a heat-sensitive image forming layer (hereinafter, also referred to as "laminate for infrared ablation") which had the carrier sheet, the barrier layer, the heat-sensitive image forming layer, and the protective layer in this order.

The CIR-RL (manufactured by Japan Carlit Co., Ltd.) as the first infrared absorbing dye and the second infrared absorbing dye was a compound having an absorption at a wavelength of 1070 nm, and a mass absorption coefficient at the wavelength of 1070 nm was 66.2 L/(g·cm) as shown in Tables 1 and 2 below. The infrared absorbing dye CIR-RL (manufactured by Japan Carlit Co., Ltd.) was the above-described compound represented by Formula (1).

In addition, the IR-813 (p-toluenesulfonate) (manufactured by Tokyo Chemical Industry Co., Ltd.) as the third infrared absorbing dye was a compound having an absorption at a wavelength of 830 nm.

[Examples 2 and 3 and Comparative Examples 1 to 3]

A laminate for infrared ablation was produced according to the same procedure as in Example 1, except that the type and content (% by mass) of each component in the barrier layer and the heat-sensitive image forming layer were changed as shown in Tables 1 and 2 below.

The ultraviolet absorber contained in the barrier layers of Example 2, Example 3, and Comparative Example 3 was 2,2',4,4'-tetrahydroxybenzophenone as shown in Table 1 below, and the 2,2',4,4'-tetrahydroxybenzophenone was a compound having substantially no absorption in a wavelength range of 900 to 1200 nm and having an absorption in a wavelength range of 300 to 400 nm.

[Comparative Example 4]

A laminate for infrared ablation was produced according to the same procedure as in Example 1, except that the laminate for an infrared ablation layer was changed to the following. Each component of the barrier layer and the heat-sensitive image forming layer is also described in Tables 1 and 2 below.

[Production of laminate for infrared ablation]

600 parts by mass of methyl isobutyl ketone was added to 50 parts by mass of an acrylic resin (Hi-pearl M5000, manufactured by Negami Chemical Industrial Co., Ltd.), 50 parts by mass of an elastomer (Nipol DN-101, NBR, manufactured by Zeon Corporation), and 100 parts by mass of carbon black (MA-8, manufactured by Mitsubishi Chemical Corporation) as an infrared absorbing pigment and mixed with a blade impeller, the obtained mixed solution was dispersed with a paint shaker, and then methyl isobutyl ketone was further added thereto so that the solid content was 15% by mass, thereby obtaining a polymer/carbon black dispersion liquid (coating solution for a heat-sensitive image forming layer).

Next, the coating solution for a heat-sensitive image forming layer was applied onto one surface of a PET film having a thickness of 125 μm [carrier sheet] using a bar coater such that a thickness after drying was 1.0 μm, and then dried for 1 minute in an oven set at 140°C to produce a laminate for an infrared ablation layer, which included the carrier sheet and the heat-sensitive image forming layer and did not include the barrier layer.

In the carbon black (MA-8, manufactured by Mitsubishi Chemical Corporation) as an infrared absorbing pigment, a mass absorption coefficient at the wavelength of 1070 nm was 49 L/(g·cm) as shown in Table 2 below.

[Table 1]

| | Barrier layer | | | | | | | | |
|---|---|---|---|---|---|---|---|---|---|
| | First infrared absorbing dye or pigment | | | Third infrared absorbing dye | | Ultraviolet absorber | | Binder | |
| | Type | Content (% by mass) | Mass absorption coefficient L/(gm·cm) | Type | Content (% by mass) | Type | % by mass | Type | % by mass |
| Example 1 | CIR-RL (dye) | 22.3 | 66.2 | IR-813 (dye) | 22.3 | None | 0 | Nitrocellulose | 55.4 |
| Example 2 | CIR-RL (dye) | 22.3 | 66.2 | IR-813 (dye) | 22.3 | Benzophenone-based※ 1 | 0.09 | Nitrocellulose | 55.31 |
| Example 3 | CIR-RL (dye) | 22.3 | 66.2 | IR-813 (dye) | 22.3 | Benzophenone-based※ 1 | 0.1 | Nitrocellulose | 55.3 |
| Comparative Example 1 | CIR-RL (dye) | 22.3 | 66.2 | None | 0 | None | 0 | Nitrocellulose | 77.7 |
| Comparative Example 2 | None | 0 | - | IR-813 (dye) | 22.3 | None | 0 | Nitrocellulose | 77.7 |
| Comparative Example 3 | None | 0 | - | IR-813 (dye) | 22.3 | Benzophenone-based※ 1 | 0.1 | Nitrocellulose | 77.6 |
| Comparative Example 4 | - | - | - | - | - | - | - | - | - |
| ※ 1: 2,2',4,4'-tetrahydroxybenzophenone | | | | | | | | | |

[Table 2]

| | Heat-sensitive image forming layer | | | | | | | | | | |
|---|---|---|---|---|---|---|---|---|---|---|---|
| | Second infrared absorbing dye or pigment | | | Third infrared absorbing dye | | Ultraviolet absorber | | Additive | | Binder | |
| | Type | Content (% by mass) | Mass absorption coefficient L/(gm·cm) | Type | Content (% by mass) | Type | % by mass | Type | % by mass | Type | % by mass |
| Example 1 | CIR-RL (dye) | 13 | 66.2 | IR-813 (dye) | 13 | Benzophenone-based※ 1 | 13.8 | Curcumin | 14.7 | Nitrocellulose | 45.5 |
| Example 2 | CIR-RL (dye) | 13 | 66.2 | IR-813 (dye) | 13 | Benzophenone-based※ 1 | 13.8 | Curcumin | 14.7 | Nitrocellulose | 45.5 |
| Example 3 | CIR-RL (dye) | 13 | 66.2 | IR-813 (dye) | 13 | Benzophenone-based※ 1 | 13.8 | Curcumin | 14.7 | Nitrocellulose | 45.5 |
| Comparative Example 1 | CIR-RL (dye) | 13 | 66.2 | None | 0 | Benzophenone-based※ 1 | 13.8 | Curcumin | 27.7 | Nitrocellulose | 45.5 |
| Comparative Example 2 | None | 0 | - | IR-813 (dye) | 13 | Benzophenone-based※ 1 | 13.8 | Curcumin | 27.7 | Nitrocellulose | 45.5 |
| Comparative Example 3 | None | 0 | - | IR-813 (dye) | 13 | Benzophenone-based※ 1 | 13.8 | Curcumin | 27.7 | Nitrocellulose | 45.5 |
| Comparative Example 4 | MA8 (pigment) | 50 | 49 | None | 0 | None (absorbed by MA8) | 0 | None | 0 | Acrylic resin※ 2 | 50 |

※ 1: 2,2',4,4'-tetrahydroxybenzophenone
※ 2 mixture of acrylic resin and nitrile rubber (mixed ratio: 50:50)

[Evaluation]

[Sensitivity]

With regard to the laminates for an infrared ablation layer produced in Examples 1 to 3, Comparative Example 1, and Comparative Example 4, IR drawing was performed on the heat-sensitive image forming layer using CDI Spark 2530 manufactured by ESKO.

In addition, with regard to the laminates for an infrared ablation layer produced in Comparative Examples 2 and 3, IR drawing was performed on the heat-sensitive image forming layer using Trendsetter (registered trademark) 800 Imager (Kodak SQUARESPOT head, exposure wavelength: 830 nm).

The amount of light used for the drawing was changed in a range of 0 to 5.0 $J/cm^2$, and the amount of drawing light in a case where Dmin after the drawing was 0.07 or less was evaluated as the sensitivity. The results are shown in Table 3 below.

[White spots in line drawing]

Using CDI Spark 2530 manufactured by ESKO, an image pattern was formed on the heat-sensitive image forming layer included in the produced laminate for an infrared ablation layer to produce a mask.

Next, from the substrate side of a commercially available water-developable flexo precursor (FW-A, manufactured by FUJIFILM Corporation), exposure (back exposure) was performed for 15 seconds from a distance of 15 cm with an exposure device in which 15 fluorescent lamps of 40 W were arranged.

Next, the photosensitive resin layer exposed by peeling off the carrier sheet of the above-described flexo precursor and the protective layer of the above-described mask were laminated and bonded to each other.

Next, from the carrier sheet side of the bonded mask, exposure (main exposure) was performed with the above-described exposure device for 8 minutes from a distance of 15 cm. Thereafter, the mask was peeled off, and development was performed for 10 minutes with a brush-type washing machine (liquid temperature: 50°C) containing an aqueous developer adjusted to have a concentration of sodium carbonate of 0.5% and a concentration of a surfactant (PIONINE D-6120, manufactured by TAKEMOTO OIL & FAT Co., Ltd.) (surfactant represented by Formula (2) described above; A: $-CH_2CH_2-$(ethylene group), $R^1$: hydrogen atom, n: 20) of 1%.

Thereafter, the obtained laminate was dried with hot air of 60°C until the moisture was removed. Thereafter, the photosensitive layer was exposed (post-exposed) with the above-described exposure device for 8 minutes from a distance of 15 cm to produce a flexographic printing plate.

Printing was performed using the above-described flexographic printing plate, and white spots in thin lines having a width of 200 μm were evaluated according to the following standard. The results are shown in Table 3 below.

<Evaluation standard>

A: no white spots
B: white spots were observed on a loupe, but could not be visually observed.
C: there were white spots which were visually observed.

[Manufacturing suitability]

The produced laminate for an infrared ablation layer was stored for 24 hours in an environment of 50°C and a relative humidity of 70%, and then the surface of the laminate for an infrared ablation layer was observed and evaluated according to the following standard. The results are shown in Table 3 below.

A: no crystal precipitate
B: with crystal precipitate

[Table 3]

| | Sensitivity J/cm$^2$ | White spots in line drawing | Manufacturing suitability |
|---|---|---|---|
| Example 1 | 1 | A | A |
| Example 2 | 1 | B | A |
| Example 3 | 1 | C | A |
| Comparative Example 1 | 1 | A | B |
| Comparative Example 2 | 2 | A | A |
| Comparative Example 3 | 2 | C | A |
| Comparative Example 4 | 3 | C | A |

From the results shown in Tables 1 to 3, in a case where the barrier layer and the heat-sensitive image forming layer did not contain the third infrared absorbing dye, it was found that the manufacturing suitability was deteriorated (Comparative Example 1).

In a case where the barrier layer did not contain the first infrared absorbing dye and the heat-sensitive image forming layer did not contain the first infrared absorbing dye, it was found that the sensitivity of the heat-sensitive image forming layer was deteriorated (Comparative Examples 2 and 3).

In addition, in a case where the barrier layer was not provided and the heat-sensitive image forming layer containing the infrared absorbing pigment not corresponding to the infrared absorbing dye was used, it was found that the sensitivity of the heat-sensitive image forming layer was further deteriorated, and white spots occurred in the line drawing in a case of being used for a flexographic printing plate (Comparative Example 4).

On the other hand, in a case where the barrier layer contained the first infrared absorbing dye and the third infrared absorbing dye, and the heat-sensitive image forming layer contained the second infrared absorbing dye and the third infrared absorbing dye, it was found that the sensitivity of the heat-sensitive image forming layer was increased, and the manufacturing suitability of the laminate for forming an image was also improved (Examples 1 to 3).

In particular, from the comparison between Examples 1 and 2 and Example 3, in a case where, in the barrier layer, the content of the compound having substantially no absorption in a wavelength range of 900 to 1200 nm and having an absorption in a wavelength range of 300 to 400 nm was 0% by mass or more and less than 0.1% by mass with respect to the mass of the barrier layer, it was found that the occurrence of white spots in the line drawing can be suppressed in a case of being used for a flexographic printing plate. Among these, in Example 1 in which the content of the UV absorbing impurity in the barrier layer was 0.05% by mass or less with respect to the mass of the barrier layer, the occurrence of white spots was further suppressed.

Explanation of References

3: barrier layer
4: heat-sensitive image forming layer
5: overcoat layer
6: carrier sheet
10: laminate for forming image

## Claims

1. A laminate for forming an image, which is for forming a mask used for manufacturing a flexographic printing plate, comprising, in the following order:

   a carrier sheet;
   a barrier layer; and
   a heat-sensitive image forming layer,
   wherein the barrier layer contains a first infrared absorbing dye,
   the heat-sensitive image forming layer contains an ultraviolet absorber and a second infrared absorbing dye,

both of the first infrared absorbing dye and the second infrared absorbing dye are a compound having an absorption at a wavelength of 1070 nm and having a mass absorption coefficient at the wavelength of 1070 nm of 50 L/(g·cm) or more, and
both of the barrier layer and the heat-sensitive image forming layer contain a third infrared absorbing dye having an absorption at a wavelength of 830 nm.

**2.** The laminate for forming an image according to claim 1,
wherein, in the barrier layer, a content of a compound having substantially no absorption in a wavelength range of 900 to 1200 nm and having an absorption in a wavelength range of 300 to 400 nm is 0% by mass or more and less than 0.1% by mass with respect to a mass of the barrier layer.

**3.** The laminate for forming an image according to claim 1 or 2,

wherein both of the first infrared absorbing dye and the second infrared absorbing dye are a compound represented by Formula (1),

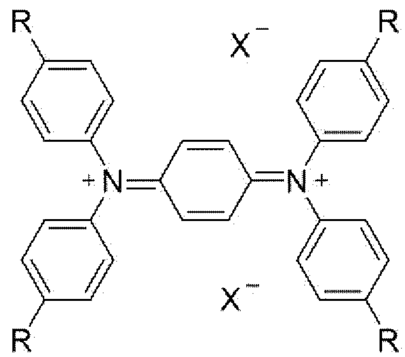

(1)

here, in Formula (1),
R represents a monovalent organic group, where a plurality of R's may be the same or different from each other, and
$X^-$ represents a monovalent anion, where a plurality of $X^-$'s may be the same or different from each other.

**4.** A manufacturing method of a flexographic printing plate having a non-image area and an image area, the manufacturing method comprising:

a mask forming step of forming an image on the heat-sensitive image forming layer included in the laminate for forming an image according to any one of claims 1 to 3 to form a mask;
a lamination step of, after the mask forming step, laminating the mask on a photosensitive resin layer of a flexographic printing plate precursor including a support and the photosensitive resin layer;
an exposure step of, after the lamination step, imagewise exposing the photosensitive resin layer through the mask;
a peeling step of, after the exposure step, peeling off the mask from the photosensitive resin layer; and
a development step of, after the peeling step, performing development using a developer to form a non-image area and an image area.

**5.** The manufacturing method of a flexographic printing plate according to claim 4,

wherein the photosensitive resin layer contains a monomer, a polymerization initiator, a base polymer, and water-dispersible particles,
the water-dispersible particles have a carbon-carbon double bond, and
a carbon-carbon double bond amount on a surface of the water-dispersible particles is 21 or less.

**6.** The manufacturing method of a flexographic printing plate according to claim 4 or 5,
wherein the developer contains 50% by mass or more of water.

**7.** The manufacturing method of a flexographic printing plate according to any one of claims 4 to 6,

wherein the developer contains a surfactant represented by Formula (2),

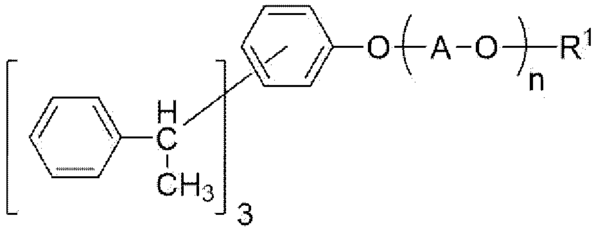

(2)

here, in Formula (2),

A represents an alkylene group having 2 to 4 carbon atoms, $R^1$ represents a hydrogen atom or a substituent, and n represents an integer of 1 to 100, in which in a case where n is an integer of 2 to 100, a plurality of A's may be the same or different from each other.

## Patentansprüche

**1.** Laminat zum Erzeugen eines Bildes, das zum Erzeugen einer Maske, die zum Herstellen einer Flexodruckplatte verwendet wird, dient, umfassend, in der folgenden Reihenfolge:

ein Trägerblatt;
eine Sperrschicht; und
eine wärmeempfindliche Bilderzeugungsschicht,
wobei die Sperrschicht einen ersten infrarotabsorbierenden Farbstoff enthält,
die wärmeempfindliche Bilderzeugungsschicht einen Ultraviolett-Absorber und einen zweiten infrarotabsorbierenden Farbstoff enthält,
sowohl der erste infrarotabsorbierende Farbstoff als auch der zweite infrarotabsorbierende Farbstoff eine Verbindung mit einer Absorption bei einer Wellenlänge von 1070 nm und mit einem Massenabsorptionskoeffizienten bei der Wellenlänge von 1070 nm von 50 L/(g·cm) oder mehr sind, und
sowohl die Sperrschicht als auch die wärmeempfindliche Bilderzeugungsschicht einen dritten infrarotabsorbierenden Farbstoff enthalten, das eine Absorption bei einer Wellenlänge von 830 nm aufweist.

**2.** Laminat zum Erzeugen eines Bildes nach Anspruch 1,
wobei bei der Sperrschicht ein Gehalt einer Verbindung, die im Wesentlichen keine Absorption in einem Wellenlängenbereich von 900 bis 1200 nm aufweist und eine Absorption in einem Wellenlängenbereich von 300 bis 400 nm aufweist, 0 Massen-% oder mehr und weniger als 0,1 Massen-% in Bezug auf eine Masse der Sperrschicht beträgt.

**3.** Laminat zum Erzeugen eines Bildes nach Anspruch 1 oder 2,

wobei sowohl der erste infrarotabsorbierende Farbstoff als auch der zweite infrarotabsorbierende Farbstoff eine Verbindung sind, die durch Formel (1) dargestellt wird,

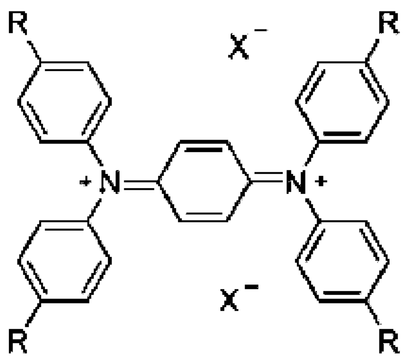

(1)

wobei in Formel (1),
R eine monovalente organische Gruppe darstellt, wobei mehrere R gleich oder voneinander verschieden sein

können, und
$X^-$ ein monovalentes Anion darstellt, wobei mehrere $X^-$ gleich oder verschieden voneinander sein können.

4. Herstellungsverfahren einer Flexodruckplatte, die einen Nichtbildbereich und einen Bildbereich aufweist, wobei das Herstellungsverfahren umfasst:

einen Maskenbildungsschritt des Erzeugens eines Bildes auf der wärmeempfindlichen Bilderzeugungsschicht, die in dem Laminat zum Erzeugen eines Bildes nach einem der Ansprüche 1 bis 3 enthalten ist, um eine Maske zu bilden;
einen Laminierungsschritt des Laminierens der Maske auf einer lichtempfindlichen Harzschicht eines Flexodruckplattenvorläufers, der einen Träger und die lichtempfindliche Harzschicht enthält, nach dem Maskenbildungsschritt;
einen Belichtungsschritt des bildweisen Belichtens der lichtempfindlichen Harzschicht durch die Maske nach dem Laminierungsschritt;
einen Ablöseschritt des Abziehens der Maske von der lichtempfindlichen Harzschicht nach dem Belichtungsschritt; und
einen Entwicklungsschritt des Durchführens von Entwicklung unter Verwendung eines Entwicklers nach dem Ablöseschritt, um einen Nichtbildbereich und einen Bildbereich zu bilden.

5. Herstellungsverfahren einer Flexodruckplatte nach Anspruch 4,

wobei die lichtempfindliche Harzschicht ein Monomer, einen Polymerisationsinitiator, ein Basispolymer und wasserdispergierbare Partikel enthält,
die wasserdispergierbaren Partikel eine Doppelbindung von Kohlenstoff-Kohlenstoff aufweisen, und
eine Doppelbindungsmenge von Kohlenstoff-Kohlenstoff auf einer Oberfläche der wasserdispergierbaren Partikel 21 oder weniger beträgt.

6. Herstellungsverfahren einer Flexodruckplatte nach Anspruch 4 oder 5,
wobei der Entwickler 50 Massen-% oder mehr Wasser enthält.

7. Herstellungsverfahren einer Flexodruckplatte nach einem der Ansprüche 4 bis 6,

wobei der Entwickler ein Tensid enthält, das durch Formel (2) dargestellt wird,

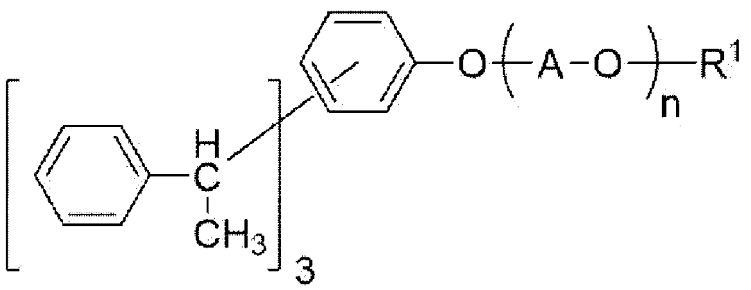

(2)

wobei in Formel (2)
A eine Alkylengruppe, die 2 bis 4 Kohlenstoffatome aufweist, darstellt, $R^1$ ein Wasserstoffatom oder einen Substituenten darstellt und n eine ganze Zahl von 1 bis 100 darstellt, wobei in einem Fall, in dem n eine ganze Zahl von 2 bis 100 ist, mehrere A gleich oder voneinander verschieden sein können.

## Revendications

1. Stratifié pour former une image, qui est destiné à former un masque utilisé pour la fabrication d'une plaque d'impression flexographique, comprenant, dans l'ordre suivant :

une feuille de support ;
une couche barrière ; et
une couche de formation d'images thermosensible,

dans lequel la couche barrière contient un premier colorant absorbant dans l'infrarouge,
la couche de formation d'images thermosensible contient un absorbeur d'ultraviolets et un deuxième colorant absorbant dans l'infrarouge,
le premier colorant absorbant dans l'infrarouge et le deuxième colorant absorbant dans l'infrarouge sont tous deux un composé ayant une absorption à une longueur d'onde de 1070 nm et ayant un coefficient d'absorption massique à la longueur d'onde de 1070 nm de 50 L/(g·cm) ou plus, et
la couche barrière et la couche de formation d'images thermosensible contiennent toutes deux un troisième colorant absorbant dans l'infrarouge ayant une absorption à une longueur d'onde de 830 nm.

**2.** Stratifié pour former une image selon la revendication 1,
dans lequel, dans la couche barrière, une teneur d'un composé n'ayant substantiellement aucune absorption dans une plage de longueurs d'onde de 900 à 1200 nm et ayant une absorption dans une plage de longueurs d'onde de 300 à 400 nm est de 0 % en masse ou plus et inférieure à 0,1 % en masse par rapport à une masse de la couche barrière.

**3.** Stratifié pour former une image selon la revendication 1 ou la revendication 2,

dans lequel le premier colorant absorbant dans l'infrarouge et le deuxième colorant absorbant dans l'infrarouge sont tous deux un composé représenté par Formule (1),

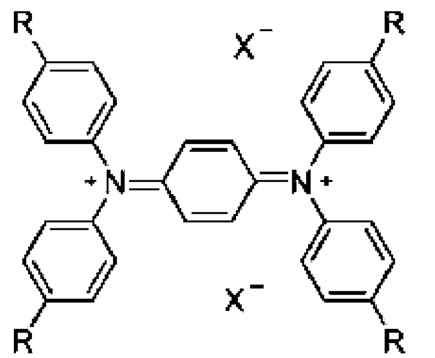

(1)

ici, dans Formule (1),
R représente un groupe organique monovalent, où une pluralité de R peuvent être identiques ou différents les uns des autres, et
$X^-$ représente un anion monovalent, où une pluralité de $X^-$ peuvent être identiques ou différents les uns des autres.

**4.** Procédé de fabrication d'une plaque d'impression flexographique ayant une zone sans image et une zone d'image, le procédé de fabrication comprenant :

une étape de formation de masque consistant à former une image sur la couche de formation d'images thermosensible incluse dans le stratifié pour former une image selon l'une quelconque des revendications 1 à 3 pour former un masque ;
une étape de stratification consistant à, après l'étape de formation de masque, stratifier le masque sur une couche de résine photosensible d'un précurseur de plaque d'impression flexographique incluant un support et la couche de résine photosensible ;
une étape d'exposition consistant à, après l'étape de stratification, exposer image par image la couche de résine photosensible à travers le masque ;
une étape de pelage consistant à, après l'étape d'exposition, retirer le masque de la couche de résine photosensible ; et
une étape de développement consistant à, après l'étape de pelage, effectuer un développement en utilisant un révélateur pour former une zone sans image et une zone d'image.

**5.** Procédé de fabrication d'une plaque d'impression flexographique selon la revendication 4,

dans lequel la couche de résine photosensible contient un monomère, un initiateur de polymérisation, un polymère de base et des particules dispersibles dans l'eau,
les particules dispersibles dans l'eau ont une liaison double carbone-carbone, et une quantité de liaison double carbone-carbone sur une surface des particules dispersibles dans l'eau est de 21 ou moins.

**6.** Procédé de fabrication d'une plaque d'impression flexographique selon la revendication 4 ou la revendication 5, dans lequel le révélateur contient 50 % en masse ou plus d'eau.

**7.** Procédé de fabrication d'une plaque d'impression flexographique selon l'une quelconque des revendications 4 à 6,

dans lequel le révélateur contient un tensioactif représenté par Formule (2),

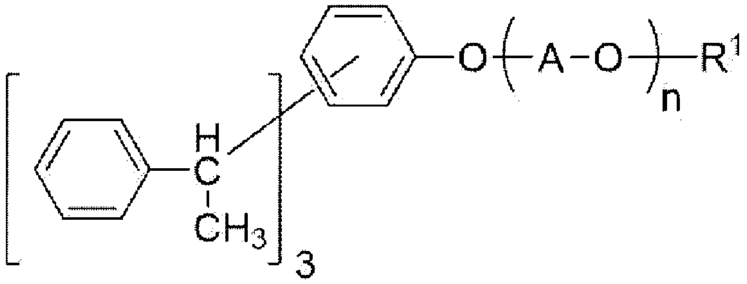

(2)

ici, dans Formule (2),
A représente un groupe alkylène ayant de 2 à 4 atomes de carbone, $R^1$ représente un atome d'hydrogène ou un substituant, et n représente un entier de 1 à 100, où dans un cas où n est un entier de 2 à 100, une pluralité de A peuvent être identiques ou différents les uns des autres.

FIG. 1

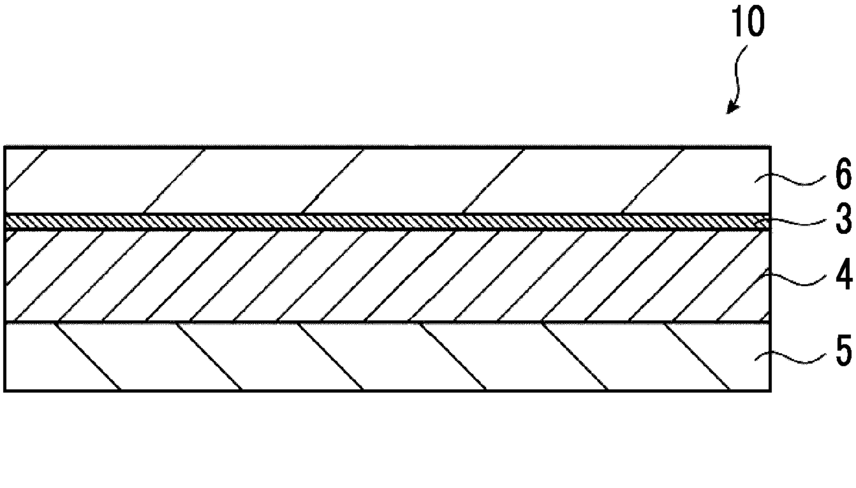

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016524718 A
- US 2019258154 A1
- JP 2011038007 A
- US 6259465 B
- WO 2020158778 A